Europäisches Patentamt

European Patent Office

Office européen des brevets

(11) Publication number:

**0 305 343**
**A2**

## EUROPEAN PATENT APPLICATION

(21) Application number: 88830335.1

(22) Date of filing: 02.08.88

(51) Int. Cl.⁴: **H 03 K 5/24**

(30) Priority: 25.08.87 IT 6773187

(43) Date of publication of application:
01.03.89 Bulletin 89/09

(84) Designated Contracting States:
AT BE CH DE ES FR GB GR IT LI LU NL SE

(71) Applicant: **MARELLI AUTRONICA S.p.A.**
**Piazza Sant'Ambrogio, 6**
**I-20123 Milano (IT)**

(72) Inventor: **Calfus, Marco**
**Strada Superga, 298**
**I-10132 Torino (IT)**

(74) Representative: **Quinterno, Giuseppe et al**
**c/o Jacobacci-Casetta & Perani S.p.A. Via Alfieri, 17**
**I-10121 Torino (IT)**

(54) A threshold comparator circuit.

(57) The circuit comprises:
an operational amplifier (OA) with an open-collector output transistor (T) and a non-inverting input connected to a source (S) of signals to be compared with a threshold level (V_s), a feedback network including a resistor (4) between the output and the inverting input of the operational amplifier (OA), and a reference voltage source (V_R) connected to the inverting input of the operational amplifier (OA) for defining the threshold level (V_s).

According to the invention, an inverter (I) is connected in the feedback network (4) between the output and the inverting input of the operational amplifier (OA). Either the output of the operational amplifier (OA) or the output of the inverter (I) can be used as the output of the threshold comparator.

FIG. 1

EP 0 305 343 A2

## Description

### A threshold comparator circuit

The present invention relates to a threshold comparator circuit and, more specifically, to a threshold comparator comprising:
an operational amplifier with an open-collector output transistor and a non-inverting input for connection to a source of signals to be compared with a threshold level,
a feedback network including a resistor between the output and the inverting input of the operational amplifier, and
a reference voltage source connected to the inverting input of the amplifier to define the threshold level.

Cheap operational amplifiers with an "open-collector" output require a resistor (known as a "pull-up" resistor) between the output and a voltage supply. This resistor and the inevitable parasitic capacitances connected to the output of the operational amplifier cause the appearance of a time constant and thus of a delay in the switching of the output of the operational amplifier from low level to high level.

The switching of the output of the operational amplifier from high level to low level, however, is not substantially affected by the pull-up resistor, since the parasitic capacitances can be discharged almost instantaneously through the output transistor of the amplifier.

Cheap operational amplifiers with "open-collector" outputs do not therefore lend themselves to use in the production of threshold comparator circuits with signals to their non-inverting inputs, in view of the fact that the feedback to the non-inverting inputs would inevitably affect the signals which are to be compared. In order to speed up the switching of the output of the comparator, the resistance of the pull-up resistor could be reduced: however, this cannot be achieved in practice, since this measure would lead to an unacceptable increase in the $I_c$ and thus in the $V_{cesat}$ of the output transistor of the operational amplifier.

This problem could actually be solved by the use of operational amplifiers with a high-speed response, having output circuits of the so-called "totem pole" type, which are, of course, much more expensive.

The object of the present invention is to enable a threshold comparator circuit with a signal to the non-inverting input to be produced, which includes a cheap type of operational amplifier provided with an open-collector output transistor, but has fast output switching when the signal exceeds the threshold.

This object is achieved according to the present invention by means of a threshold comparator circuit of the type specified above, whose main characteristic lies in the fact that an inverter is connected in the feedback network between the output and the inverting input of the operational amplifier.

In the threshold comparator circuit according to the invention, either the output of the operational amplifier or the output of the inverter can be used as the output.

Further characteristics and advantages of the present invention will become clear from the detailed description which follows with reference to the appended drawings, provided by way of non-limiting example, in which:

Figure 1 is an electrical diagram of a threshold comparator according to the invention, and

Figure 2 is a series of graphs which show the traces of the signals generated in the comparator circuit of Figure 1.

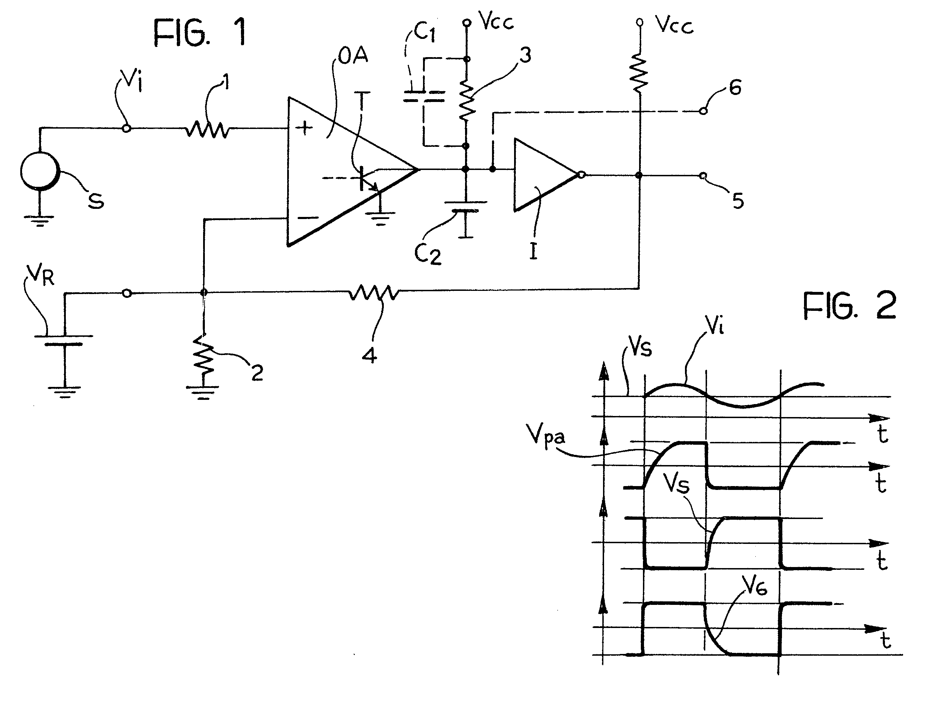

With reference to Figure 1, a threshold comparator circuit according to the invention comprises an operational amplifier OA of the type including an open-collector output transistor T, for example, an LM 139 produced by National Semiconductors.

A source S which generates a voltage signal $V_i$ which is to be compared with a threshold voltage level is connected through a resistor 1 to the non-inverting input of the amplifier. A reference voltage source $V_R$ is connected to the inverting input of the amplifier OA, for defining the threshold voltage level. A resistor 2 is connected between the inverting input of the amplifier and earth.

A pull-up resistor, indicated 3, is connected between the output of the amplifier OA and a voltage supply source $V_{cc}$. The parasitic capacitances associated with this resistor are indicated $C_1$ and $C_2$. In particular, $C_1$ is the parasitic capacitance introduced by the resistor, whilst $C_2$ represents the sum of the parasitic capacitances existing between the output of OA and earth.

The output of the amplifier OA is connected to the input of an inverter I whose output is connected through a resistor 4 to the inverting input of the amplifier.

The inverter may be produced, for example, using a 7404, 7414 or 7406 device. A resistor $R_I$ is conveniently interposed between the output I and $V_{cc}$ in order to make the feedback to the inverting input precise, this being necessary if a 7406 is used (which has an "open-collector"-type output) and in any event convenient even if a 7404 or a 7414 (with "totem pole"-type outputs) is used.

Either a terminal 5 connected to the output of the inverter or a terminal 6 connected to the output of the operational amplifier OA may be used as the output of the entire comparator circuit.

In Figure 2, a sample trace of the signal supplied to the input of the threshold comparator is indicated $V_i$. The threshold voltage level is indicated $V_s$. The corresponding output trace provided by a prior-art non-inverting threshold comparator circuit including an operational amplifier of the type with an open-collector output is indicated $V_{pa}$. Such a non-inverting threshold comparator circuit corresponds to the circuit of Figure 1 without the inverter I. As can be seen from Figure 2, the signal $V_{pa}$ switches from low level to high level in correspondence with the upward crossing of the threshold $V_s$ by the signal $V_i$. These changes from low level to high level take place with a certain delay due to the time constant introduced by the pull-up resistor 3 and by the associated parasitic capacitances. The leading edges representing the switching of $V_{pa}$ from high level to low level, however, are very steep and show an extremely short delay. In effect, during the switching from high level to low level, the parasitic capacitances $C_1$ and $C_2$ associated with the resistor 3 can be discharged rapidly through the collector-emitter path of the output transistor T of the operational amplifier.

As the trace of the signal $V_{pa}$ shows, threshold comparators with signals to the non-inverting input produced with operational amplifiers having open-collector outputs have a considerable delay in the detection of the upward crossing of the threshold by the signal.

In Figure 2, the traces of the signals provided at the output terminals 5 and 6 of the threshold comparator according to the invention are correspondingly indicated $V_5$ and $V_6$. The presence of the inverter circuit I causes the slow switching of the output of the operational amplifier to be associated in practice with the downward crossing of the threshold by the signal $V_i$. The rapid switching of the operational amplifier OA, however, is associated with the crossing of the threshold by the signal $V_i$ in its ascending phase.

Naturally, the principle of the invention remaining the same, the forms of embodiment and details of constructions may be varied widely with respect to those described and illustrated purely by way of non-limiting example, without thereby departing from the scope of the present invention.

Thus, for example, the threshold voltage could be OV in order to detect the zero crossing of the signal $V_i$.

**Claims**

1. A threshold comparator circuit comprising:
an operational amplifier (OA) with an open-collector output transistor (T) and a non-inverting input for connection to a source (S) of the signal to be compared with a threshold level ($V_s$),
a feedback network (4) between the output and the inverting input of the operational amplifier (OA), and a reference voltage source ($V_R$) connected to the inverting input of the amplifier (OA) for defining the threshold level,
characterised in that an inverter (I) is connected in the feedback network between the output and the inverting input of the operational amplifier (OA).

2. A threshold comparator circuit according to Claim 1, characterised in that the output (5) of the inverter (I) is used as the output of the comparator.

3. A threshold comparator cicruit according to Claim 1, characterised in that the output (6) of the operational amplifier (OA) is used as the output of the comparator.

FIG. 1

FIG. 2